# FASCICULE DE BREVET EUROPEEN

(11) **EP 0 725 436 B1**
(45) Date de publication et mention de la délivrance du brevet: **28.04.2004**
(21) Numéro de dépôt: 96400226.5
(22) Date de dépôt: 01.02.1996
(51) Int. Cl.: H01L 21/8246, H01L 27/112

(54) **Procédé de fabrication d'une mémoire morte en technologie MOS, et mémoire ainsi obtenue**
ROM-Herstellungsverfahren in MOS-Technologie und so hergestellter Speicher
Method of manufacturing a ROM in a MOS-technology and memory fabricated with this method

(30) Priorité: 03.02.1995 FR 9501278
(43) Date de publication de la demande: 07.08.1996
(60) Demande divisionnaire: 03075649.8
(73) Titulaire: ATMEL NANTES SA, 44300 Nantes (FR)
(72) Inventeur: Rödde, Klaus, F-44470 Carquefou (FR); Le Neel, Olivier, F-44850 Le Cellier (FR)
(74) Mandataire: Fréchède, Michel

(56) Documents cités:
- EP-A- 0 333 583
- US-A- 5 149 667
- PATENT ABSTRACTS OF JAPAN vol. 012 no. 089 (E-592) ,23 Mars 1988 & JP-A-62 224069 (HITACHI LTD) 2 Octobre 1987,
- IEEE Vol. ED-33n 4 April 1986 pp.450-457

## Description

L'invention concerne un procédé de fabrication d'une mémoire morte de type ROM (*Read Only Memory*, en vocable anglo-saxon) en technologie MOS, et la mémoire ainsi obtenue.

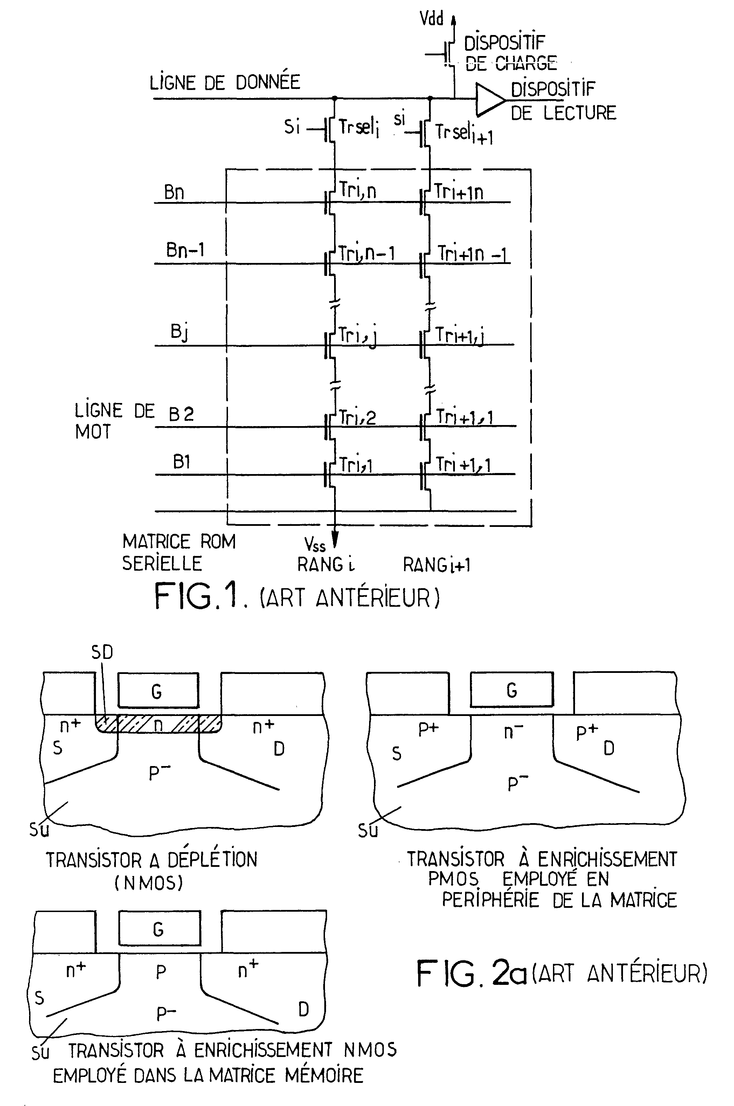

A l'heure actuelle, l'architecture permettant la meilleure densité d'intégration d'une mémoire morte en technologie MOS, comprend, ainsi que représenté en figure 1, une structure de type NON-ET ou sérielle, permettant la mémorisation de N mots (ou word, en langage anglo-saxon) de n bits, par l'intermédiaire d'une structure matricielle d'adresses i, j de Nxm transistors MOS, notés Trᵢ₁, Trᵢₙ avec i ∈ 1,m, j ∈ 1,m. N transistors Trᵢ₁ à Trᵢₙ sont ainsi connectés en série, électrodes drain-source communes, et forment un circuit de blocage de bits de même rang i pour chaque mot successif 1 à m. Chaque circuit de blocage est sélectionné dans la matrice complète correspondante, pour lecture, au moyen d'un transistor de sélection Trselᵢ. La programmation d'un bit de rang i, dans chaque mot, est effectuée par l'intermédiaire de la tension de seuil Vt des transistors Trᵢⱼ, ces transistors étant configurés soit comme transistor de type à enrichissement, soit comme transistor à déplétion. Les transistors de sélection sont de type à enrichissement. La lecture de l'information programmée au niveau d'un point mémoire, constitué par un transistor Trᵢⱼ, est effectuée de la manière ci-après :
- précharge de la ligne de donnée au potentiel d'alimentation Vdd à l'aide d'un transistor ou dispositif de charge ;
- maintien du potentiel de toutes les lignes de sélection Sk, k ≠ i, des circuits de blocage k, k ≠ i au potentiel de référence Vss, la ligne de sélection Si étant portée au potentiel d'alimentation Vdd ;
- maintien de toutes les lignes de commande des électrodes de grilles des transistors Trᵢⱼ, Bₕ, h ≠ j, au potentiel d'alimentation Vdd, à l'exception de la ligne Bⱼ mise au potentiel de référence Vss, ligne qui commande la grille du transistor Trᵢⱼ et le point mémoire correspondant. Si le transistor Trᵢⱼ précité a été programmé comme transistor à enrichissement, la ligne de donnée, préchargée, ne se décharge pas, le transistor Trᵢⱼ étant bloqué. Un circuit de détection, non représenté, connecté à la ligne de donnée, enregistre le potentiel Vdd et délivre un signal d'état logique correspondant.
Si au contraire le transistor Trᵢⱼ a été programmé comme transistor à déplétion, le transistor Trᵢⱼ est conducteur et la ligne de donnée se décharge à travers l'ensemble des transistors en série de même rang i, y compris le transistor de sélection Trselᵢ. Le circuit de détection enregistre une diminution du potentiel de la ligne de donnée et délivre un signal d'état logique correspondant.
Pour le fonctionnement de ce type de cellule mémoire, on constate qu'il n'est donc pas nécessaire de contrôler parfaitement la tension de seuil des transistors MOS à déplétion, car il suffit de garantir un courant minimal lorsque le potentiel appliqué sur la grille Bⱼ est égal à la tension de référence Vss, et qu'en conséquence, il n'est pas nécessaire de bloquer ce transistor.
Afin de réaliser ce type de composant sous forme de circuit intégré, il est donc nécessaire de réaliser, à partir d'un substrat de silicium de type P par exemple, des transistors à déplétion, des transistors enrichis de type PMOS ou NMOS, ainsi que représenté en figure 2a. Les transistors à déplétion et à enrichissement, de type NMOS, sont employés dans la matrice pour réaliser, en fonction de leur programmation, les points mémoire correspondants, alors que les transistors à enrichissement, de type PMOS, sont employés en périphérie de la matrice, pour réaliser les transistors de sélection par exemple. Dans la figure 2a, les lettres S, D, G désignent les zones de source, drain et grille de ces transistors, les lettres P, P⁺, P⁻ et n, n⁺, n⁻ les types de conduction correspondants, après dopage du substrat SU. Dans les transistors de type à déplétion, on rappelle que la zone SD désigne une zone de type de conduction n réalisant une liaison de faible résistance, de l'ordre de 100 Ω, équivalente à un court-circuit, entre les zones de source S et de drain D.

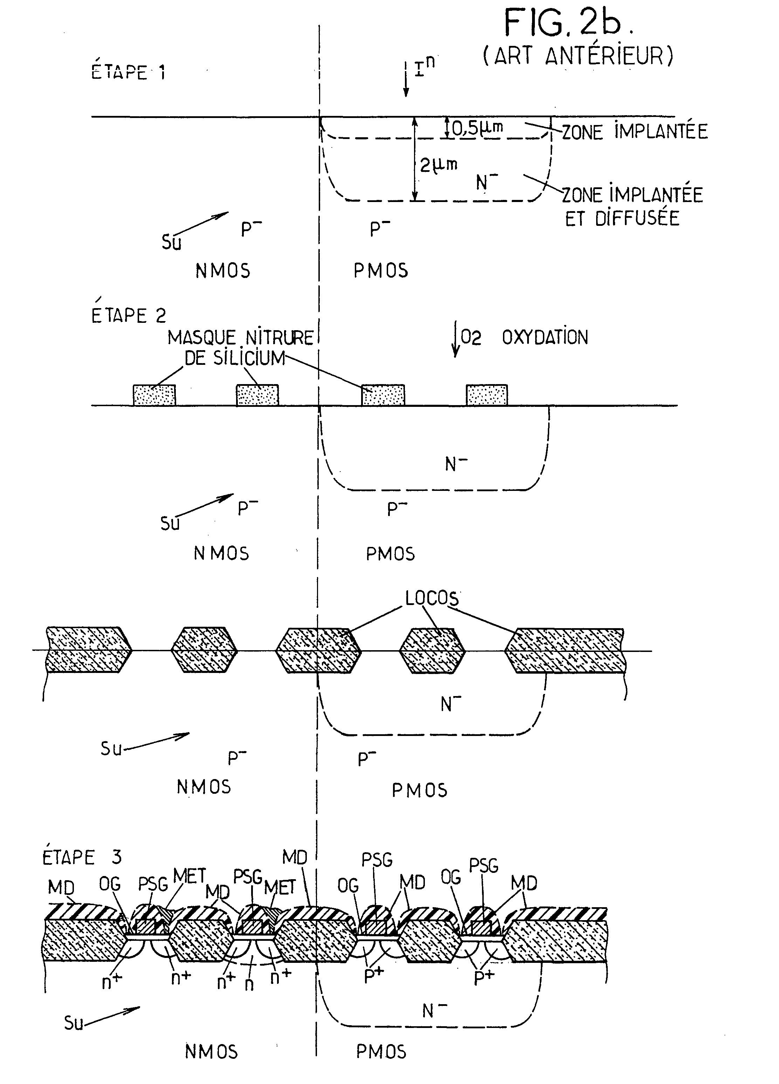

Un procédé classique, pour réaliser des matrices de points mémoire correspondantes, consiste, ainsi que représenté en figure 2b,
- en une étape 1, à partir d'un substrat SU de silicium de type P⁻, à subdiviser ce substrat en deux zones, symbolisées par la ligne verticale en pointillés, chaque zone étant destinée à la création de transistors PMOS respectivement NMOS. Dans la zone PMOS, une implantation ionique négative à faible énergie, de l'ordre de 80 keV, est réalisée pour former une zone implantée de l'ordre de 0,5 µm puis diffusée par traitement thermique, à 1000°C pendant 24 heures par exemple, pour former un caisson diffusé de type N⁻ sur 2 µm environ ;
- en une étape 2, un masquage au moyen d'un masque de nitrure de silicium est effectué pour définir des zones actives des transistors PMOS et NMOS respectivement, l'étape de masquage est suivie d'une étape d'oxydation permettant d'obtenir sur les zones non masquées de la surface du substrat SU des zones d'oxyde de silicium épaisses, plus communément désignées par LOCOS. La deuxième vue de l'étape 2, après retrait du masque de nitrure de silicium, montre l'existence de zones libres de la surface du substrat SU entre les zones de LOCOS, sur lesquelles les transistors PMOS respectivement NMOS sont implantés ensuite ;
- en une étape 3, plus particulièrement destinée à l'implantation des transistors PMOS et NMOS dans laquelle une étape d'oxydation sacrificielle (oxyde Kooi) des zones libres de la partie NMOS est réalisée, à des fins de nettoyage, suivie d'un masquage puis d'une implantation de type n représentée en pointillés dans la zone NMOS, cette implantation étant destinée à constituer la zone SD des transistors à déplétion NMOS, tel que représenté en figure 2a.
Ces opérations sont suivies, pour l'ensemble des zones libres de la surface du substrat SU, d'une étape de croissance d'oxyde de grille OG de dépôt de polysilicium, puis de création par photolithogravure des zones de polysilicium de grille PSG.
Puis sur les parties PMOS et NMOS respectivement, on définit ensuite par implantation ionique :
n⁺ côté NMOS , n⁺ = 10¹⁹ à 10²⁰ cm⁻³
P⁺ côté PMOS , P⁺ = 10¹⁹ à 10²⁰ cm⁻³
les zones de drain et de source des transistors à déplétion NMOS et des transistors à enrichissement PMOS.
Les étapes de dépôt d'un matériau diélectrique MD puis d'une métallisation MET viennent ensuite pour réaliser les connexions appropriées.

Le procédé ainsi mis en oeuvre permet de réaliser, au moyen d'étapes différentes, d'une part, les transistors NMOS à déplétion, et, d'autre part, les transistors PMOS ou NMOS à enrichissement utilisés à la périphérie de la matrice.

Il ne permet toutefois pas, pour la définition du canal n du transistor à déplétion et du transistor PMOS, une opération commune d'implantation de type n en raison de la pollution entraînée par cette diffusion du caisson n pour les transistors voisins.

Le document US-4608748 prévoit une implantation ionique pour former ces canaux. Toutefois, l'opération de formation des canaux des transistors à déplétion est ici effectuée en fin de processus, ce qui ne permet pas de simplifier la fabrication de la mémoire.

La présente invention a pour objet de remédier aux inconvénients précités par la mise en oeuvre d'un procédé simplifié.

Un autre objet de la présente invention est la mise en oeuvre d'un procédé de fabrication d'une mémoire morte en technologie MOS dans lequel certaines étapes peuvent être regroupées, ce qui permet une optimisation de déroulement du procédé.

Un autre objet de la présente invention est enfin la mise en oeuvre de matrices de transistors de mémoire MOS présentant des caractéristiques spécifiques de symétrie par la mise en oeuvre du procédé, les transistors à enrichissement et à déplétion présentant sensiblement un même profil d'implantation.

Le procédé de fabrication d'une mémoire morte en technologie MOS, objet de la présente invention, est conforme à l'énoncé de la revendication 1 ci-après.

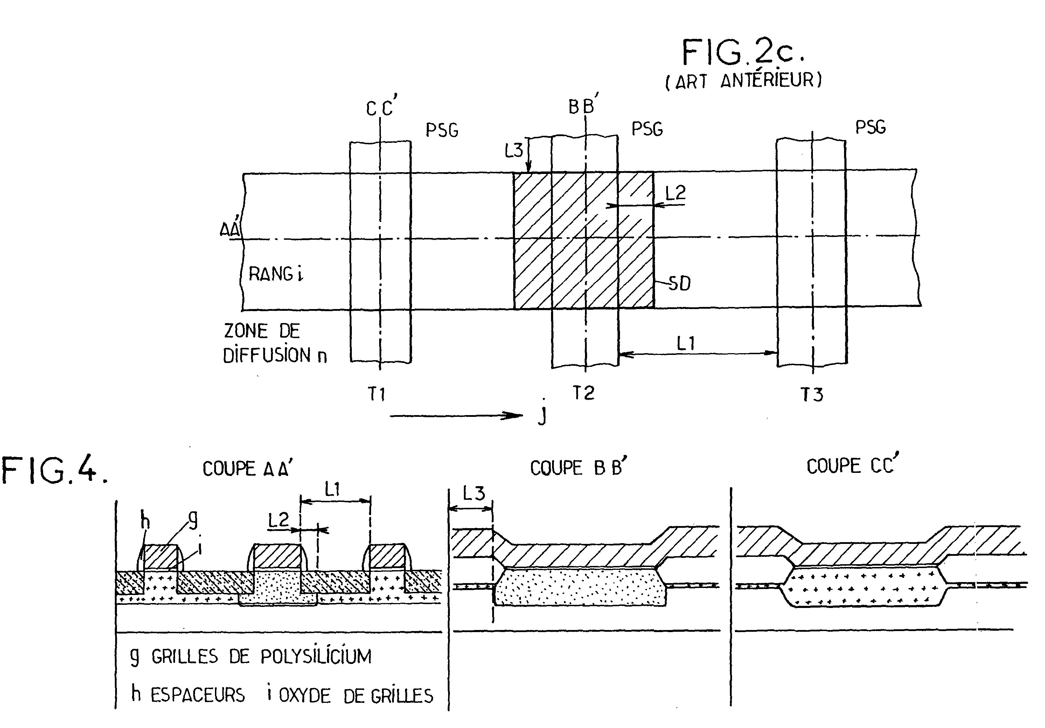

Il sera mieux compris à la lecture de la description et à l'observation des dessins ci-après, dans lesquels, outre les figures 1, 2a et 2b relatives à l'art antérieur, et la figure 2c relative à une vue partielle d'une colonne de transistors de la matrice, dans leur implantation,

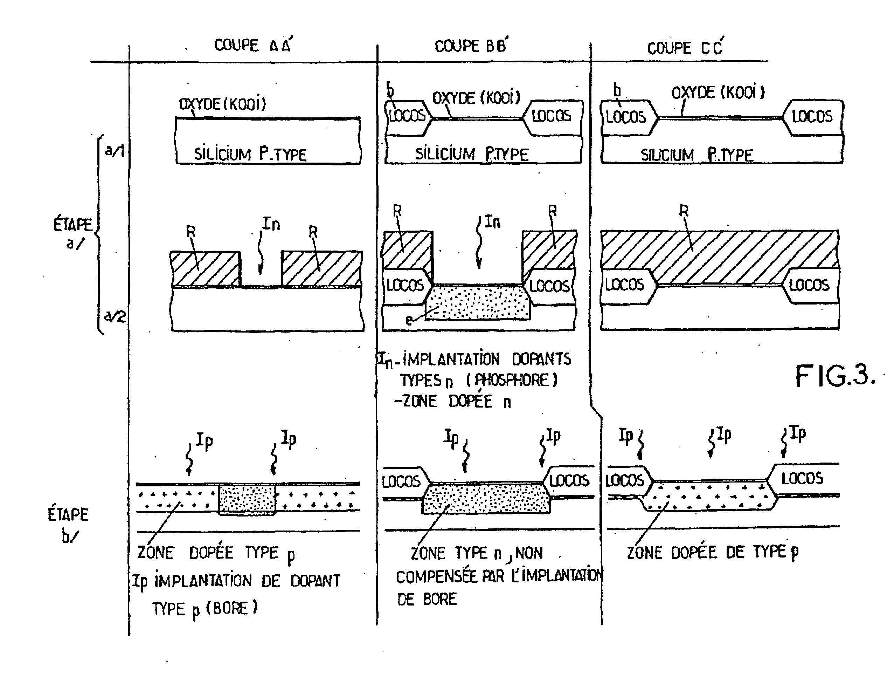

- la figure 3 représente, selon les plans de coupe de la figure 2c :
- une vue en coupe longitudinale AA' des transistors,
- une vue en coupe transversale BB' d'un transistor à déplétion,
- une vue en coupe transversale CC' d'un transistor à enrichissement, pendant l'étape de définition des caissons rétrogrades de type de conduction opposé à celui du substrat et des transistors à déplétion, respectivement pendant l'étape de définition des caissons rétrogrades de même type de conduction que celui du substrat et d'un transistor à enrichissement ;
   - la figure 4 représente les vues en coupe AA', BB' et CC' précitées, dans l'étape ultérieure de définition des contacts électriques en vue d'une opération de métallisation ;
   - la figure 5 représente une vue de dessus d'un élément matriciel obtenu par la mise en oeuvre du procédé selon l'invention,
   - la figure 6 représente une vue en coupe selon le plan de coupe AA de la figure 5, en particulier la structure symétrique des transistors à déplétion et à enrichissement, structure obtenue du fait de la mise en oeuvre du procédé objet de l'invention.

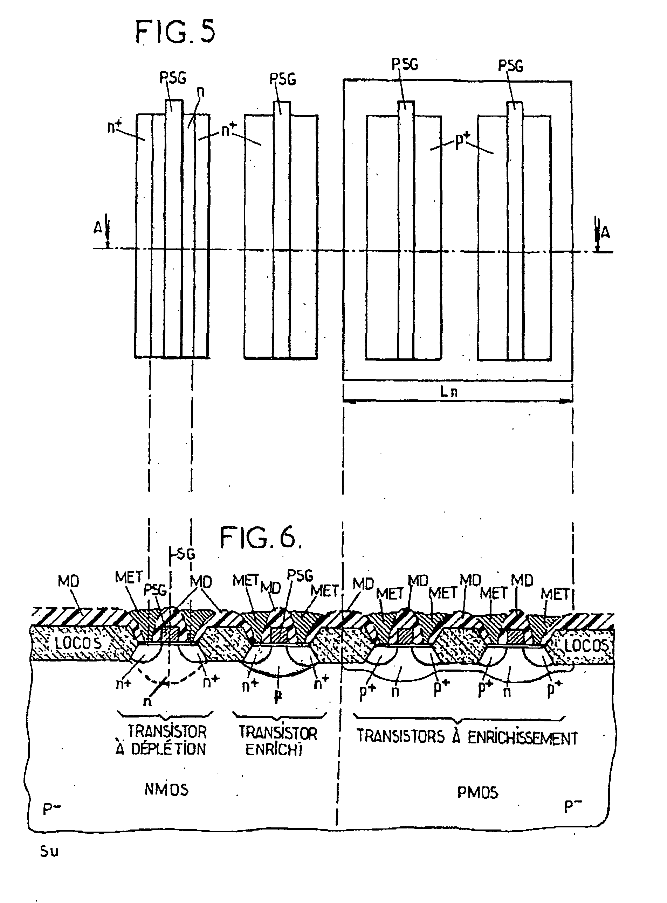

Une description plus détaillée du procédé de fabrication d'une mémoire morte en technologie MOS, objet de la présente invention, sera maintenant donnée en liaison avec la figure 2c, relative à l'art antérieur, et les figures 3, 4 et suivantes.

Préalablement à la description proprement dite du procédé, objet de la présente invention, certains éléments et indications relatifs à l'implantation d'une matrice de transistors Trᵢⱼ formant point mémoire de la mémoire morte correspondante seront donnés en liaison avec la figure 2c, cette figure représentant en vue de dessus l'implantation de trois transistors consécutifs Trᵢⱼ d'une chaîne de transistors constituant les cellules mémoire des bits de rang i d'une pluralité de mots dans la mémoire morte ROM considérée. Par simplification, les transistors précités sont référencés T1, T2 et T3 sur la figure 2c.

Sur la figure précitée, on indique que les transistors T1 et T3 sont, par exemple, des transistors enrichis, de type NMOS, alors que le transistor T2 est un transistor à déplétion, également de type NMOS. Ces transistors sont réalisés sur un substrat de type P dans lequel un caisson diffusé de type N a été réalisé, ce caisson de type N étant représenté par la zone de diffusion n sur la figure 2c. Chaque transistor à enrichissement de type NMOS, T1 et T3, est donc muni d'une structure semblable à celle représentée en figure 2a. Ainsi, chacun d'eux comprend essentiellement une zone de grille formée par une zone en polysilicium, notée PSG, laquelle est transversale à la zone de diffusion n précédemment mentionnée.

En ce qui concerne le transistor à déplétion T2, on indique que celui-ci bien entendu comporte la même zone de polysilicium de grille PSG pour former un transistor à déplétion de type NMOS, tel que représenté en figure 2a. En outre, ainsi que représenté par la zone hachurée sur la figure 2c relativement au transistor T2 à déplétion, celui-ci comprend une zone, dite de vignette, permettant de définir le transistor à déplétion T2 précité, cette zone, notée SD, correspondant à la zone SD correspondante telle que représentée pour le transistor à déplétion en figure 2a.

Sur la figure 2c, par convention, on indique que :
- la ligne en pointillés AA' désigne la trace d'un plan de coupe dans le sens de la longueur des transistors T1, T2, T3,
- la ligne BB' représente la trace d'un plan de coupe dans le sens de la largeur du transistor à déplétion T2,
- la ligne CC' représente la trace d'un plan de coupe dans le sens de la largeur ou transversalement aux transistors enrichis T1 ou T3.
On indique bien entendu que les plans de coupe précités sont orthogonaux à la surface du substrat.

D'une manière générale, on indique que le procédé, objet de la présente invention, consiste, au cours d'étapes préalables, à partir d'un substrat de matériau semi-conducteur, tel que du silicium de type P par exemple, à réaliser une étape de définition des zones actives n et p à partir d'opérations de masquage au moyen de masque de nitrure de silicium, cette opération de définition des zones étant suivie d'une opération d'oxydation localisée, puis de retrait du masque, et enfin d'oxydation sacrificielle de type Kooi.

Ces opérations correspondent à des opérations de type classique pour la réalisation de mémoires mortes de type ROM en technologie MOS et, à ce titre, elles ne seront pas décrites en détail. On indique simplement que l'étape consistant à définir les zones actives n et p permettent d'obtenir les zones de diffusion n sur le substrat telles que représentées sur la figure 2c par exemple. L'obtention de ces zones permet alors la mise en oeuvre du procédé, objet de la présente invention, pour la réalisation de transistors programmés, du type à déplétion ou à enrichissement, pour constituer les chaînes de transistors telles que représentées en figure 1. Dans le mode de réalisation décrit, on indique que les transistors T1, T3 à enrichissement sont des transistors de type NMOS, alors que le transistor à déplétion T2 est également un transistor de type NMOS. Ces transistors sont donc destinés à constituer les chaînes de transistors telles que représentées en figure 1, pour constituer la matrice d'adresse ij précitée. En ce qui concerne les transistors de sélection par exemple, ces transistors étant disposés en dehors de la matrice proprement dite, ceux-ci sont constitués sous forme de transistors à enrichissement de type PMOS.

Suite aux étapes préalables précitées, le procédé, objet de la présente invention, tel que représenté en figure 3, consiste de manière particulièrement avantageuse, en une étape a), à effectuer, par masquage, une définition dans le substrat SU de caissons rétrogrades de même type de conduction que le type de conduction du substrat.

L'étape a) précitée peut alors être suivie d'une étape b) consistant à effectuer, par masquage, une définition dans le substrat de caissons rétrogrades de type de conduction opposé à celui du substrat SU. Cette étape consiste également à réaliser simultanément une définition des transistors à déplétion.

D'une manière générale, on indique que la succession des étapes a) et b) peut être inversée, comme le montre la Figure 3, la définition des caissons rétrogrades de type de conduction opposé à celui du substrat et la définition simultanée des transistors à déplétion étant réalisées préalablement à la définition par masquage de caissons rétrogrades de même type de conduction que le type de conduction du substrat.

Sur la figure 3, on a représenté l'opération a) consistant à réaliser des caissons rétrogrades de type n, le substrat de type P ayant été dopé pour obtenir un substrat de type P⁻.

La figure 3 montre les vues selon les plans de coupe AA', BB', CC' de la figure 2c lors de la mise en oeuvre dans une étape a1) d'un processus de masquage au moyen d'une résine photosensible R, représentée en a2), une implantation de dopant, notée In, est effectuée, cette implantation étant effectuée à partir de dopant de type n tel que du phosphore, pour constituer une zone dopée constituant un caisson rétrograde de type n, obtenu par une opération connue sous le vocable anglo-saxon de masquage n-well. La zone de caissons rétrogrades de type n est représentée sur la coupe BB', cette zone étant destinée à réaliser la vignette ou zone SD du transistor à déplétion de type NMOS T2. Au contraire, les transistors T1 et T3 sont exempts d'une telle implantation de caissons rétrogrades en raison de la présence, ainsi que montré sur la coupe CC' de la figure 3, du masque de résine R sur l'ensemble de la zone correspondante.

L'étape de définition des caissons rétrogrades de même type de conduction que le type de conduction du substrat est alors suivie, ainsi que représenté en figure 3 au niveau des mêmes coupes AA', BB' et CC', suite à la suppression du masque de résine R, d'une étape de définition dans le substrat de caissons rétrogrades de type de conduction opposé à celui-ci et simultanément de définition des transistors à déplétion. Cette étape correspondant à l'étape b) précitée, est représentée sur les coupes AA', BB' et CC' de la figure 3. Elle est effectuée par implantation de dopant de type P, noté IP, le dopant utilisé étant par exemple du bore. Cette implantation est effectuée de façon à réaliser, au niveau de la zone de diffusion de type n initiale, une zone dopée de type P au niveau des transistors T1 et T3 de type NMOS à enrichissement, ainsi que représenté sur les coupes AA' et CC', alors que dans la zone de vignette SD du transistor à déplétion T2, zone de type n implantée précédemment, l'implantation de type P précitée reste superficielle, la zone sous-jacente à cette zone superficielle étant une zone non compensée par l'implantation de bore, et donc constituée par une zone de type n.

L'étape précitée, représentée en figure 3, est alors suivie d'étapes classiques telles que le retrait de l'oxyde de protection, une étape de croissance d'un oxyde de grille, d'ajustement de tension de seuil, puis de dépôt de définition des grilles pour constituer les zones polysilicium PSG. Les étapes successives d'implantation des plots de contact et des zones de diffusion n pour constituer les transistors de type NMOS destinés à former les transistors NMOS à enrichissement ou à déplétion, puis de définition des zones de diffusion par masquage PMOS pour constituer les transistors à enrichissement de type PMOS destinés à former les transistors de sélection par exemple, sont alors effectuées de manière classique.

Ces étapes de masquage NMOS et PMOS sont elles-mêmes suivies d'étapes d'isolement inter-polymétalliques, de définition des contacts, puis de dépôt de premier métal et de définition des lignes de métal, métal 1, de passivation, de définition des ouvertures des plots et finalement de recuit final.

Sur la figure 4, on a représenté les étapes de définition des diffusions de type P pour réaliser les transistors de type PMOS par masquage PMOS et d'isolement inter-polymétal suite à la création des zones de polysilicium de grille PSG, puis d'espaceurs notés h, sur et au voisinage de l'oxyde de grille noté OG.

D'une manière générale, on indique que le procédé, objet de la présente invention met en oeuvre une technologie à doubles caissons rétrogrades obtenus après définition des zones de diffusion par oxydation localisée. Les caissons rétrogrades sont obtenus par une double implantation ionique à haute énergie en une seule étape de masquage, implantation n-well masquée, implantation p-well plein champ. Les ions d'implantation sont soumis, conformément à un aspect particulier du procédé, objet de la présente invention, à une énergie comprise entre 300 et 500 keV. L'implantation est réalisée à partir d'un dispositif d'implantation classique du type canon à ions, lequel, à ce titre, ne sera pas décrit.

Contrairement à la technique antérieure décrite en liaison avec les figures 2a et 2b, les caissons rétrogrades ainsi obtenus ne sont aucunement diffusés, car directement définis en profondeur grâce à la forte énergie d'implantation utilisée.

Les autres étapes du procédé, objet de l'invention, sont par contre classiques, telles que ajustement de tension de seuil, d'oxyde de grille, de création des zones en polysilicium de grille ainsi que la création des zones drain-source et d'interconnexion.

En ce qui concerne la fabrication des transistors à déplétion, tel que le transistor T2 sur la figure 3, conformément au procédé, objet de la présente invention, ces transistors sont définis en même temps que les caissons de type de conduction opposé au type de conduction du substrat, ainsi que décrit précédemment. Ce mode opératoire permet alors de définir une zone de type n dans le canal d'un transistor NMOS, c'est-à-dire de constituer la vignette SD permettant d'abaisser la tension de seuil du transistor au-dessous de la valeur 0 volt, rendant ainsi ce transistor normalement conducteur.

Le procédé, objet de la présente invention, permet de ne rajouter aucune étape spécifique pour la définition des transistors à déplétion.

En outre, en raison du fait que les caissons rétrogrades ne sont aucunement diffusés, ce mode opératoire n'entraîne aucune baisse de densité d'intégration, les distances L1, p1p1 dans la mémoire morte et distances L3, n⁺n⁺ ne sont pas affectées.

Le procédé, objet de la présente invention, est également applicable de la même manière, à partir d'un substrat de type n et d'un caisson rétrograde de type p. Dans un tel cas toutefois, les transistors à déplétion ne nécessitent pas l'implantation de caissons rétrogrades de type P⁻.

Le procédé, objet de la présente invention, permet également la réalisation de transistors à enrichissement de type PMOS tels que représentés en figure 2a, ce type de transistors étant utilisé à la périphérie de la matrice de points mémoire.

Pour réaliser ces transistors, on indique que ceux-ci peuvent l'être conformément à la mise en oeuvre du procédé, objet de la présente invention, dans lequel ces transistors à enrichissement de type PMOS peuvent être réalisés simultanément à la réalisation des transistors à déplétion.

Dans ce cas, les étapes de mise en oeuvre du procédé tel que décrit précédemment, tant pour les transistors à déplétion que pour les transistors à enrichissement PMOS, sont sensiblement identiques, sauf bien entendu pour ce qui concerne les étapes de création de zones de source et de drain, lesquelles impliquent une implantation de dopant de type de conduction opposé, par implantation ionique.

Ainsi, pour la création de transistors à déplétion de type NMOS, ainsi que décrit précédemment, dans le caisson de type n, type de conduction opposé à celui du substrat de type P⁻, sont implantées, par masquage, des zones de conduction de type N⁺ opposé au type de conduction du substrat, pour créer les zones de source et de drain, le caisson rétrograde de type n jouant le rôle de canal, c'est-à-dire de vignette SD ainsi que décrit précédemment.

Au contraire, pour la création simultanée des transistors à enrichissement de type PMOS, l'implantation de zones de source et de drain SD est réalisée au moyen de dopant de type P⁺ dans le caisson rétrograde de type n, ce qui permet ainsi de réaliser les transistors à enrichissement de type PMOS précités. On comprend bien sûr que le caractère de simultanéité de création des transistors à déplétion de type NMOS et des transistors à enrichissement de type PMOS concerne toutes les étapes préalables à l'implantation des zones de source et de drain précitées. On rappelle en effet que, du fait de l'implantation de type N⁺ pour les zones de source et de drain des transistors à déplétion, la zone de conduction de type n du caisson rétrograde joue pour les zones de source et de drain précitées le rôle de court-circuit, alors qu'au contraire, dans le cas d'une implantation de type P⁺ pour la création des zones de source et de drain des transistors PMOS à enrichissement, la zone de conduction de type n du caisson rétrograde, créée préalablement, joue le rôle d'un isolant vis-à-vis du substrat P⁻ pour les zones de source et de drain précitées.

Une description plus détaillée de la structure d'une mémoire morte en technologie MOS obtenue par la mise en oeuvre du procédé, objet de la présente invention, au niveau des transistors à déplétion de type NMOS et des transistors à enrichissement de type PMOS sera maintenant donnée en liaison avec les figures 5 et 6.

La figure 5 représente en vue de dessus une succession d'un transistor à déplétion, d'un transistor à enrichissement et de deux transistors PMOS à enrichissement.

Ainsi que représenté en outre sur la figure 6 précitée, cette figure étant représentée en coupe selon un plan de coupe tel que la ligne AA de la figure 5, mais incluant cette fois les transistors à enrichissement de type PMOS destinés à constituer les transistors de sélection, on indique que tous les transistors MOS programmés à déplétion et tous les transistors de sélection présentent, dans le plan de coupe précité du substrat, un même profil d'implantation. Sur la figure 6, on a représenté le profil d'implantation des transistors précités, les caissons rétrogrades de type n de chacun des transistors précités présentant un même profil d'implantation mais étant représentés en pointillés en ce qui concerne les transistors à déplétion, respectivement en trait continu en ce qui concerne les transistors de type PMOS à enrichissement. La représentation en traits pointillés respectivement continu précités a pour seul objet de souligner la différence de fonction entre les caissons rétrogrades précités dans le cas où ceux-ci concernent un transistor de type NMOS à déplétion, respectivement un transistor de type PMOS à enrichissement.

Ainsi qu'on l'a représenté sur la figure 6, chaque transistor programmé à déplétion présente, par rapport à un plan de symétrie de grille, noté SG, le plan de symétrie de grille étant un plan orthogonal à la surface du substrat séparant en deux parties symétriques la zone de grille constituée en matériau de polysilicium de grille PSG, une zone d'implantation de type de conduction opposé au type de conduction du substrat, la zone de type n représentée sur la figure 6 précitée. Cette zone d'implantation est sensiblement symétrique par rapport au plan de symétrie de grille SG. Dans la zone d'implantation de type de conduction opposé à celui du substrat, sont également contenues, pour chaque transistor à déplétion respectivement à enrichissement de type PMOS, une première et une deuxième zone d'implantation situées dans le substrat, entre la zone de polysilicium de grille PSG et les zones d'oxyde de silicium épaisses adjacentes de type LOCOS. La première et la deuxième zone d'implantation sont destinées à constituer les zones de source et de drain et sont ainsi placées symétriquement par rapport au plan de symétrie de grille SG de chaque transistor programmé à déplétion, respectivement transistor de sélection. La première et la deuxième zone d'implantation présentent, pour chaque transistor à déplétion, un type de conduction opposé à respectivement, pour chaque transistor de sélection, un même type de conduction que celui du substrat. La zone d'implantation précitée joue le rôle de court-circuit entre la première et la deuxième zone d'implantation pour chaque transistor à déplétion et de caisson d'implantation isolant vis-à-vis du substrat pour chaque transistor à enrichissement.

## Revendications

1. Procédé de fabrication d'une mémoire morte en technologie MOS, ladite mémoire comprenant une matrice formée d'une pluralité de chaînes de transistors MOS de type soit à enrichissement, soit à déplétion, reliées chacune à un transistor de sélection situé en périphérie de ladite matrice,
ledit procédé comprenant, suite à une étape d'oxydation de protection (KOOI) de la surface d'un substrat de silicium d'un premier type de conduction (P), les étapes suivantes :
a)
- masquer partiellement (R) la surface du substrat,
- doper par implantation ionique (In) d'un second type de conduction (n) opposé au premier type de conduction, les zones libres du substrat,
- et retirer le masque du substrat,
b) doper, par implantation ionique (Ip) du premier type de conduction (p), la surface du substrat, pour former :
* dans les parties du substrat précédemment masquées à l'étape a), des caissons rétrogrades du premier type de conduction (p) formant les canaux des transistors à enrichissement (NMOS),
* et, dans des parties non masquées à l'étape a), des caissons rétrogrades du second type de conduction (n) non compensés par l'implantation du premier type de conduction (Ip), formant :
. les canaux des transistors à déplétion (NMOS),
. et les canaux des transistors de sélection (PMOS),
c) et poursuivre la fabrication de la mémoire notamment en retirant l'oxyde de protection (KOOI) et en formant la grille, le drain et la source des transistors.

2. Procédé selon la revendication 1, **caractérisé en ce que** l'implantation ionique de l'étape a) est plus profonde que l'implantation ionique de l'étape b).

3. Procédé selon la revendication 1 ou 2, **caractérisé en ce que** les étapes a) et b) sont interverties.

4. Mémoire morte en technologie MOS, obtenue par la mise en oeuvre du procédé selon l'une des revendications 1 à 3, mémoire dans laquelle un mot de m bits est mémorisé par l'intermédiaire de chaînes de transistors MOS connectés en cascade à une ligne de donnée, chaque chaîne étant constituée par des transistors MOS programmés, soit de type à enrichissement, soit de type à déplétion, lesdits transistors MOS programmés formant sur un substrat de matériau semi-conducteur une matrice de points mémoire adressables séparés par des roues d'oxyde de silicium épaisses (LOCOS) adjacentes et reliés à une ligne de donnée par un transistor de sélection,
**caractérisée en ce que** tous les transistors MOS programmés à déplétion (NMOS A DEPLETION) et tous les transistors de sélection (PMOS A ENRICHISSEMENT) présentent, dans un plan de coupe du substrat contenant un alignement desdits transistors, un même profil d'implantation du canal.

5. Mémoire morte selon la revendication 4, **caractérisée en ce que** chaque transistor programmé à déplétion respectivement de sélection présente, par rapport à un plan de symétrie de grille (SG) dudit transistor, une zone d'implantation de type de conduction opposé au type de conduction du substrat, ladite zone d'implantation étant sensiblement symétrique par rapport audit plan de symétrie de grille (SG) , et, contenues dans ladite zone d'implantation de type de conduction opposé :
- une première et une deuxième zone d'implantation situées dans le substrat entre ladite zone de polysilicium de grille (PSG) et lesdites zones d'oxyde de silicium épaisses adjacentes, symétriquement audit plan de symétrie de grille (SG), pour former la zone de drain (D) respectivement de source (S) dudit transistor programmé respectivement de sélection, la première et la deuxième zone d'implantation présentant, pour chaque transistor à déplétion, un type de conduction opposé à respectivement, pour chaque transistor de sélection, un même type de conduction que celui du substrat, ladite zone d'implantation de type de conduction opposé à celui du substrat formant un caisson rétrograde jouant le rôle de court-circuit (SD) entre la première et la deuxième zone d'implantation pour chaque transistor à déplétion, respectivement de caisson d'implantation isolant vis-à-vis du substrat pour chaque transistor à enrichissement.

## Claims

1. Method of manufacture of a read-only memory using MOS technology, the said memory comprising a matrix formed of a plurality of arrays of MOS transistors either of the enhancement-mode type or of the depletion-mode type, each connected to a selection transistor situated at the periphery of the said matrix, the said method comprising, following a step of protective oxidation (KOOI) of the surface of a silicon substrate of a first conduction type (P), the following steps:
a)
- partially masking (R) the surface of the substrate,
- doping the free zones of the substrate by ion implantation (In) of a second conduction type (n) opposite to the first conduction type,
- and removing the mask from the substrate,
b) - doping the surface of the substrate by ion implantation (Ip) of the first conduction type (p) in order to form:
* in the parts of the substrate previously masked at step a), retrograde wells of the first conduction type (p) forming channels of the enhancement-mode transistors (NMOS),
* and, in parts not masked at step a), retrograde wells of the second conduction type (n) not compensated by the implantation of the first conduction type (Ip), forming:
. the channels of the depletion-mode transistors (NMOS),
. and the channels of the selection transistors (PMOS),
c) - and continuing the manufacture of the memory in particular by removing the protective oxide (KOOI) and forming the gate, the drain and the source of the transistors.

2. Method as claimed in Claim 1, **characterised in that** the ion implantation of step a) is deeper than the ion implantation of step b).

3. Method as claimed in Claim 1 or 2, **characterised in that** the steps a) and b) are carried out in reverse order.

4. Read-only memory using MOS technology obtained by carrying out the method as claimed in one of Claims 1 to 3, in which a m-bit word is memorised by means of arrays of MOS transistors connected in cascade to a data line, each array consisting of programmed MOS transistors either of the enhancement-mode type or of the depletion-mode type, the said programmed MOS transistors forming on a substrate of semiconductor material a matrix of addressable memory points separated by thick zones of silicon oxide which are adjacent and connected to a data line by a selection transistor, **characterised in that** all the programmed depletion-mode MOS transistors (DEPLETION MOS) and all the selection transistors (ENHANCEMENT PMOS) have, in a sectional plane of the substrate containing an alignment of the said transistors, the same implantation profile of the channel.

5. Read-only memory as claimed in Claim 4, **characterised in that** each programmed depletion-mode transistor or, respectively, selection transistor has, relative to a gate symmetry plane (SG) of the said transistor, an implantation zone of the conduction type opposite to the conduction type of the substrate, the said implantation zone being substantially symmetrical relative to the said gate symmetry plane (SG), and, contained in the said implantation zone of opposite conduction type:
- a first and a second implantation zone which are situated in the substrate between the said polysilicon gate zone (PSG) and the said adjacent thick silicon oxide zones, symmetrically with respect to the said gate symmetry plane (SG), in order to form the drain zone (D) or respectively the source zone (S) of the said programmed transistor or, respectively, selection transistor, the first and the second implantation zone having for each depletion-mode transistor, a conduction type opposite to that of the substrate and, respectively, for each selection transistor, the same conduction type as that of the substrate, the said implantation zone of the conduction type opposite to that of the substrate forming a retrograde well which plays the part of a short-circuit between the first and the second implantation zones for each depletion-mode transistor and, respectively of an insulating implantation well with regard to the substrate for each enhancement-mode transistor.

## Patentansprüche

1. ROM - Herstellungsverfahren in MOS-Technologie, wobei der ROM-Speicher eine Matrix aufweist, die aus mehreren MOS - Transistorketten entweder vom Typ Anreicherung oder Verarmung besteht, wobei jede der Ketten an einen auf der Peripherie der besagten Matrix gelegenen Auswahltransistor angeschlossen ist, wobei das besagte Verfahren auf Grund eines Oxidationsschrittes zum Schutz (KOOI) der Oberfläche eines Siliziumsubstrats mit einer ersten Leitungsart (p) folgende Schritte aufweist :
a)
- teilweises Maskieren der Substratoberfläche ( R ),
- Dotieren der freien Bereiche des Substrats durch Ionenimplantierung (In) einer der ersten Leitungsart entgegengesetzten zweiten Leitungsart (n),
- Entfernen der Substratmaske,
b) Dotieren der Substratoberfläche durch Ionenimplantierung (Ip) der ersten Leitungsart (p), um folgendes zu bilden :
• die Kanäle der Anreicherungstransistoren (NMOS) bildende retrograde Wannen der ersten Leitungsart (p) in den vorher im Schritt a) maskierten Substratteilen,
• und in den im Schritt a) nicht maskierten Teilen, retrograde Wannen der zweiten, durch die Implantierung der ersten Leitungsart (p) nicht kompensierten Leitungsart (n), die folgendes bilden :
- die Kanäle der Verarmungstransistoren (NMOS),
- und die Kanäle der Auswahltransistoren (PMOS),
c) und Fortsetzen der Speicherherstellung insbesondere durch das Entfernen des Schutzoxids (KKOI) und durch Bildung des Transistorgatters, des Drains und der Quelle des Transistors.

2. Verfahren nach Anspruch 1, **dadurch gekennzeichnet, dass** die Ionenimplantierung des Schrittes a) tiefer als die Ionenimplantierung des Schrittes b) ist.

3. Verfahren nach Anspruch 1 oder 2, **dadurch gekennzeichnet, dass** die Schritte a) und b) vertauscht werden.

4. ROM in MOS- Technologie, der durch die Ausführung nach einem der Ansprüche 1 bis 3 erhalten wird, ein Speicher, bei dem ein Wort mit m Bit über kaskadenförmig an eine Datenleitung angeschlossene MOS - Transistorketten gespeichert wird, wobei jede Kette aus programmierten MOS -Transistoren besteht, welche entweder Anreicherungs - oder Verarmungstransistoren sein können, wobei die programmierten MOS - Transistoren auf einem aus einem Halbleitermaterial bestehenden Substrat eine Matrix adressierbarer, durch angrenzende, dicke Siliziumoxidpfade getrennte und an eine durch einen Auswahltransistor an eine Datenleitung angeschlossene Speicherpunkte gebildet sind, **dadurch gekennzeichnet, dass** alle programmierten Verarmungs - MOS - Transistoren (VERARMUNGS-NMOS) und alle Auswahltransistoren (ANREICHERUNGS - PMOS) in einer Schnittebene des eine Ausrichtung der besagten Transistoren aufweisenden Substrats dasselbe Kanalimplantierungsprofil aufweisen.

5. ROM nach Anspruch 4, **dadurch gekennzeichnet, dass** jeder programmierte Verarmungstransistor bzw. Auswahltransistor in Bezug auf eine Symmetrieebene des Gatters (SG) des besagten Transistors einen Implantierungsbereich mit der der Leitungsart des Substrats entgegengesetzten Leitungsart aufweist, wobei der Implantierungsbereich im wesentlichen symmetrisch in Bezug auf die besagte Symmetrieebene des Gatters (SG) ist und folgendes in dem besagten Implantierungsbereich der entgegengesetzten Leitungsart beinhaltet:
- einen ersten und einen zweiten Implantierungsbereich in dem symmetrisch zur besagten Gattersymmetrieebene (SG) gelegenen Substrat zwischen dem besagten Polysiliziumgatter (PSG) - Bereich und den besagten dicken angrenzenden Siliziumoxidbereichen, um den Drain (D) - bzw. Quellenbereich (S) des besagten programmierten bzw. Auswahltransistors zu bilden, wobei der besagte erste und zweite Implantierungsbereich für jeden Verarmungstransistor eine dem Substrat entgegengesetzte Leitungsart bzw. für jeden Auswahltransistor dieselbe Leitungsart wie das Substrat aufweist, wobei der Implantierungsbereich mit der dem Substrat entgegengesetzten Leitungsart eine retrograde Wanne bildet, die eine Kurzschlussrolle (SD) zwischen dem ersten und zweiten Implantierungsbereich für jeden Verarmungstransistor bzw. für jeden Anreicherungstransistor die Rolle der gegenüber dem Substrat isolierenden retrograden Wanne spielt.
